# EUROPEAN PATENT APPLICATION

(11) **EP 2 477 214 A1**
(43) Date of publication of application: **18.07.2012**
(21) Application number: 12151211.5
(22) Date of filing: 16.01.2012
(51) Int. Cl.: H01L 21/687, H01L 21/673, H01L 21/67, C23C 16/44, C23C 16/458, C23C 16/48, C30B 33/00

(54) **Electronic part positioning jig**

(30) Priority: 17.01.2011 JP 2011007181
(71) Applicant: Ibiden Co., Ltd., Ogaki-shi Gifu 503-8604 (JP)
(72) Inventor: Hirose, Keiji, Gifu, 503-2321 (JP); Ogasawara, Osamu, Gifu, 503-2321 (JP); Ishida, Koji, Gifu, 503-2321 (JP); Yamada, Yoshiyuki, Gifu, 501-0695 (JP)
(74) Representative: HOFFMANN EITLE

(57) **Abstract**

An electronic part positioning jig is provided, which includes a positioning member which is made of carbon and positions an element part, and a platform which supports the positioning member on a plane. The platform includes a frame member which receives the positioning member, and a body portion which fixes the frame member. The positioning member is sandwiched between the frame member and the body portion so as to be displaceable on the body portion by the frame member being fixed to the body portion by joining means.

## Description

### BACKGROUND OF THE INVENTION

### Field of the Invention

The present invention relates to an electronic part positioning jig which positions an element part and a base when the element part and the base are brazed.

### Description of the Related Art

A positioning jig is used in a case where an element part is brazed to a base (lead frame). Specifically, a positioning jig is used when a semiconductor package serving as an electronic part is joined to a lead frame serving as the base by a brazing material, such as solder. The electronic part positioning jig accommodates an electronic part in a recess, and places a lead frame thereon to position the electronic part and the lead frame by a positioning pin or the like. The brazing material such as solder is pinched between the electronic part and the lead frame, and these are heated within a furnace to thermally melt the brazing material to join the electronic part to the lead frame.

For example, JP-A-H3-170379 describes a semiconductor package positioning jig. Fig. 7 is an exploded perspective view of a related-art semiconductor package positioning jig. A semiconductor package positioning jig 501 is divided into two, that is, a body 505 formed with a plurality of housing portions 503, and a plurality of positioning members 509 which house semiconductor packages 507, respectively and freely slide in the housing portions 503, and positioning is performed for each positioning member 509.

The electronic part positioning jig is formed of a heat-resistant material, such as carbon or ceramics. It is thought that, if electronic parts or the like are heat-treated at high temperature (for example, 200 to 600°C), a problem of positional deviation of the electric parts occurs due to a difference in the thermal expansion coefficient between the lead frame as the base and the electronic part positioning jig.

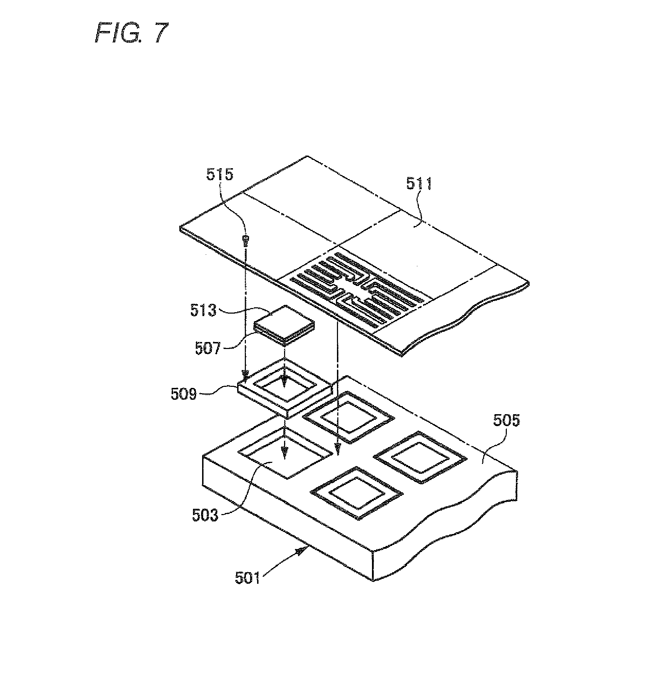

According to the above-described related-art semiconductor package positioning jig 501, it is thought that, as the positioning members 509 freely slide within the housing portion 503, each positioning member 509 slides according to the thermal expansion of the lead frame 511, a difference in thermal expansion coefficient between the lead frame 511 and the material of the semiconductor package positioning jig 501 can be absorbed, and the semiconductor packages 507 and the lead frame 511 can be joined together by a brazing material 513 with high precision. In addition, as shown in Fig. 7, the electronic part positioning jig 501 includes positioning pins 515 for positioning the semiconductor packages 507 and the lead frame 511.

In the above-described related-art semiconductor package positioning jig 501, the positioning members 509 are slidably arranged in the housing portions 503 of the body 505. Therefore, if the whole semiconductor package positioning jig 501 is erected at an angle close to the vertical direction or in an inverted state, the positioning members 509 and the semiconductor packages 507 may fall off the platform.

Additionally, since the positioning members 509 are chipped or worn while being repeatedly used, it is necessary to replace some of the positioning members.

### SUMMARY OF THE INVENTION

The present invention has been made in view of the above circumstances, and an object of the present invention is to provide an electronic part positioning jig which includes a positioning member for positioning an element part and a platform for supporting the positioning member, and which prevents the positioning member and the element part from coming off the platform even when the platform is inverted while the positioning member is easily replaceable.

(1) According to an illustrative embodiment of the present invention, there is provided an electronic part positioning jig comprising a positioning member which is made of carbon and positions an element part, and a platform which supports the positioning member on a plane. The platform includes a frame member which receives the positioning member, and a body portion which fixes the frame member. The positioning member is sandwiched between the frame member and the body portion so as to be displaceable on the body portion by the frame member being fixed to the body portion by joining means.

According to the above configuration, the positioning member is arranged on the body portion of the platform, and the frame member fixed to the body portion by the joining means sandwiches the positioning member between the frame member and the body portion. The positioning member sandwiched by the body portion and the frame member is made displaceable on the plane of the body portion. Thereby, as the positioning member is displaced (slides freely) on the plane, each positioning member slides according to the thermal expansion of the base, and a difference in the thermal expansion coefficient between the base and the material of the electronic part positioning jig is absorbed. In addition, even if the whole electronic part positioning jig is erected in the vertical direction or inverted, the positioning member does not fall off the platform, and if the positioning member is provided with the pin, the base and the element part also do not fall off the platform. Additionally, since the body portion and the frame member can be separated from each other by removing the joining means which joins the body portion and the frame member, the positioning member can be replaced without damaging the positioning member.

(2) In the electronic part positioning jig according to (1), the positioning member may be divided into a plurality of positioning members, and each of the plurality of divided positioning members may include an engaging portion which engages with an engaging portion of an adjacent divided positioning member, and only outer peripheral edges of positioning members which are arranged outside may be sandwiched by the frame member.

According to the above configuration, the plurality of positioning members are arranged adjacent to each other horizontally and vertically on the body portion of the platform, and the positioning members which are arranged outside have outer peripheral edges sandwiched by the body portion and the frame member, whereby falling off thereof is suppressed. The positioning members which are arranged inside adjacent to the outside positioning members whose falling off is suppressed have the engaging portions at adjacent portions sandwiched by the outside positioning members and the body portion, whereby falling off thereof is suppressed. That is, all the positioning members become slidable, falling off thereof is suppressed. Additionally, even in the positioning members which are adjacent inside, a positioning member can be replaced without damaging the positioning members by removing the joining means which joins the body portion and the frame member. Additionally, as finely divided positioning members are provided, even if the thermal expansion coefficient of the base and the electronic part positioning jig are different from each other, the thermal stress to be generated can be made small.

(3) In the electronic part positioning jig according to (1), the joining means may include a male screw which is inserted through and fastened to a hole formed to pass through the frame member or the body portion.

According to the above configuration, as the mail screw inserted through the body portion from the back side thereof is screwed into the hole formed to pass through the frame member, the frame member is separably fixed to the body portion, and the replacement of the frame member and the positioning member becomes easy.

(4) In the electronic part positioning jig according to any one of (1) to (3), the frame member may be dividable into a plurality of frame members.

According to the above configuration, in a case where some of the plurality of positioning members require replacement due to factors such as chipping, wear, soiling, or the like, if only the frame member, which directly or indirectly fixes a target positioning member which requires replacement, is released, the target positioning member can be detached, and the other positioning members which do not require replacement remain fixed, thus reducing replacement work.

(5) In the electronic part positioning jig according to any one of (1) to (4), a surface of the positioning member may be provided with a positioning pin.

According to the above configuration, if the positioning pin is inserted into a positioning hole formed in the base, the interval between the positioning members can be set to a predetermined interval.

(6) In the electronic part positioning jig according to (5), the positioning pin may include a pin inserted into a pin hole formed in the positioning member from a back surface.

According to this configuration, a pin to be inserted into or pulled out of the pin hole is used, so that replacement can be made even if the pin is worn.

(7) In the electronic part positioning jig according to (6), the positioning pin may include a protruding portion which protrudes from the surface of the positioning member, and a base end portion opposite to the protruding portion, and the base end portion may include a large-diameter portion having a diameter larger than that of the protruding portion.

According to the above configuration, since the base end portion is formed with the large-diameter portion having a diameter lager than that of the protruding portion, the pin does not slip out from a front side of the positioning member, and if the frame member and the body portion are separated from each other, the pin can be easily replaced.

(8) In the electronic part positioning jig according to any one of (5) to (7), the positioning pin may be made of metal.

According to this configuration, the pin is made of metal, so that the wear of the pin can be reduced, and the lifespan of the pin can be prolonged.

(9) In the electronic part positioning jig according to any one of (1) to (8), the carbon of the positioning member may be a C/C composite material, a graphite material, a carbon material in which glassy carbon is coated on a surface of the C/C composite material or the graphite material, or a carbon material in which a coat of pyrolytic carbon is formed on the surface of the C/C composite material or the graphite material.

According to this configuration, since the positioning member is made of carbon, wettability with a brazing material is low, and even if the brazing material leaks out, joining to the positioning member can be prevented. Additionally, the carbon is soft, and even if friction with the element part or the base is caused, the element part or the base is not worn or damaged.

According to the electronic part positioning jig according to the above embodiment, even if the platform which supports the positioning member for positioning an element part is inverted, the positioning member and the element part cannot be made to easily fall off the platform. Additionally, since the body portion and the frame member can be separated from each other by removing the joining means, the positioning member can be replaced without damaging the positioning member.

### BRIEF DESCRIPTION OF THE DRAWINGS

The above and other aspects of the present invention will become more apparent and more readily appreciated from the following description of illustrative embodiments of the present invention taken in conjunction with the attached drawings, in which:
Fig. 1 is a cross-sectional view of an electronic part positioning jig according to Embodiment I of the present invention;
Fig. 2A is a plan view of a related-art electronic part positioning jig according to a comparative example, and Fig. 2B is a plan view of an electronic part positioning jig according to Embodiment 2 of the present invention;
Fig. 3 is a cross-sectional view of an electronic part positioning jig according to a modified example which includes engaging portions at adjacent portions of positioning members;
Fig. 4 is a cross-sectional view of an electronic part positioning jig according to a modified example in which a frame member is divided;
Fig. 5 is a cross-sectional view of an electronic part positioning jig according to a modified example in which a positioning member is provided with a pin;
Fig. 6 is a cross-sectional view of an electronic part positioning jig according to a modified example; and
Fig. 7 is an exploded perspective view of a related-art semiconductor package positioning jig.

### DETAILED DESCRIPTION

Illustrative embodiments of the present invention will be described below with reference to the drawings.

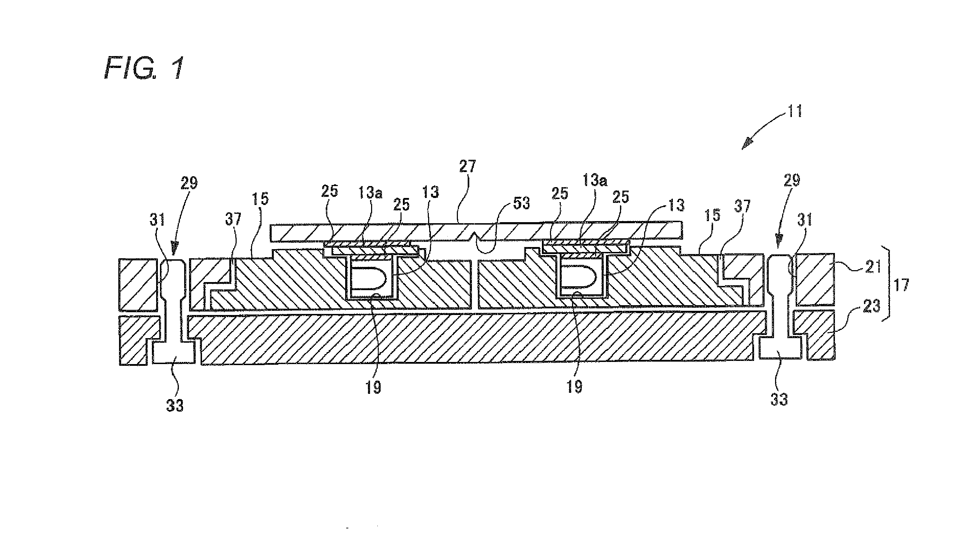

Fig. 1 is a cross-sectional view of an electronic part positioning jig according to Embodiment 1.

The electronic part positioning jig 11 according to the present embodiment generally includes positioning members 15 which is made of carbon and respectively position element parts 13, and a platform 17 which supports the positioning members 15 on a plane. Each positioning member 15 has an electronic part housing portion 19 which houses an element part 13 in an exposed manner. The platform 17 includes a frame member 21 which receives (catches) the positioning members 15, and a body portion 23 which fixes the frame member 21. In the present embodiment, the element parts 13 are semiconductor elements, and a base 27 to be described below is a ceramic substrate.

Since the positioning members 15 are made of carbon, wettability with a brazing material 25 is low, and even if the brazing material 25 leaks out, joining to the positioning members 15 can be prevented. Additionally, since the positioning members 15 are made of carbon, which is soft, even if friction with the element parts 13 or the base 27 (ceramic substrate) is caused, the element parts 13 and the base 27 are not worn or damaged. The positioning members 15 may be any kind of carbon, and may include a C/C composite material, a graphite material, a carbon material in which glassy carbon is coated on the surface of the C/C composite material or the graphite material, a carbon material in which a coat of pyrolytic carbon is formed on the surface of the C/C composite material or the graphite material, or the like. Among these, the graphite material may be favorably used. The graphite material is carbon which is heated at high temperature and subjected to crystallization and is particularly soft, so that the material is easily processed. Further, the graphite material does not wear or damage the element parts 13 or the base 27 even if friction with the element parts 13 or the base 27 is caused.

The C/C composite material is a carbon fiber reinforced carbon composite material.

The carbon material in which glassy carbon is coated on the surface of the C/C composite material or the graphite material is formed by coating pitch obtained by heat-treating polyvinyl chloride, phenol resin, furan resin, COPNA resin, or the like on the surface of the C/C composite material or the graphite material, and forming a coat of glassy carbon by carbonization.

The carbon material in which a coat of pyrolytic carbon is formed on the surface of the C/C composite material or the graphite material is obtained by forming a pyrolyzed coat of hydrocarbon gas, such as methane, ethane, propane, butane, or ethylene, on the surface of the C/C composite material or the graphite material in a CVD furnace.

The element parts 13 may include a container of a hermetic package, electronic parts such as a thermistor, a surge absorber, a resistor and a capacitor, connecting components such as a conductor pin, or the like, in addition to the semiconductor elements. The base 27 may include a resin substrate, a metal substrate, a lead frame, TAB (Tape Automated Bonding), a film substrate, or the like, in addition to the ceramic substrate.

The frame member 21 may be any kind of materials which have heat resistance. The frame member 21 may include, for example, ceramics such alumina, zirconia, silicon nitride, aluminum nitride, and carbon, metals such as iron-based alloys such as stainless steel and copper alloys such as white copper, nickel silver, bronze, and brass, or the like. The frame member 21 is preferably carbon, and more preferably a graphite material. Since the frame member 21 is present on the same level as the positioning members 15 which house the element parts 13, carbon is preferable because carbon is strong in thermal shock and does not wear or damage the element parts 13 or the base 27 even if friction with the element parts 13 or the base 27 is caused. The graphite material is more preferable because the material is particularly soft among carbon members.

The body portion 23 may be any kind of materials which have heat resistance. The body portion 23 may include, for example, ceramics such alumina, zirconia, silicon nitride, aluminum nitride, and carbon, metals such as iron-based alloys such as stainless steel and copper alloys such as white copper, nickel silver, bronze, and brass, or the like. As the material of the body portion 23, preferably, the same material as the frame member 21 is used. This is because, if the same material is used for the body portion 23 and the frame member 21, there is no difference in thermal expansion over the whole temperature region, and therefore, stress (shear stress) is not easily applied to joining means 29 which joins the frame member 21 and the body portion 23.

The positioning members 15 are sandwiched by fixing the frame member 21 of the platform 17 to the body portion 23 of the platform 17 by the joining means 29. In a case where the body portion 23 and the frame member 21 are allowed to be disassembled, a screw is preferably used as the joining means 29. The screw allows the platform 17 to be disassembled without any damage. The joining means 29 is desirably a male screw 33 that is inserted through and fastened to a hole 31 formed to pass through the frame member 21 or the body portion 23. As a female screw, a nut may be used, or a female screw may be directly formed in the frame member 21 or the body portion 23. As the male screw 33 inserted through the body portion 23 from the back side thereof is screwed into the hole 31 (a female screw and a buried nut) formed to pass through the frame member 21, the frame member 21 is separably fixed to the body portion 23, and the replacement of the frame member 21 and the positioning members 15 become easy.

In a case where metal is used for the male screw 33, if the metal is exposed to high temperature or used for a long period of time, the metal is carburized, and the male screw 33 cannot be loosened. In this case, therefore, the frame member 21 or the body portion 23 in which a female screw to be screwed to the male screw 33 may be destroyed to be disassembled. The female screw may be formed in either the body portion 23 or the frame member 21. The body portion 23 is preferably configured as one piece body in view of preventing deflection. The frame member 21 can be divided into a plurality of pieces, and therefore, it is preferable that the female screw is formed in the frame member 21 so as not to destroy the frame member 21. This is because the frame member 21 is smaller than the body portion 23 and the frame member 21 is a frame-shape, and thus, the frame member is thin and can be easily destroyed.

The joining means 29 may be any kind of means which does not bond the frame member 21 and the body portion 23, in addition to the above-described screw. For example, fixation may be made by a method, such as a fitting pin which engages by a proper fitting force, or a snap nut. Although the joining means 29 may be any kind of materials, metal is preferably used in a case where the fitting pin is used. Since the metal has significantly great strength, the fitting pin can be made thin, and the size of the electronic part positioning jig 11 can be made small. In this case, the material to be used for the fitting pin may include metals such as iron alloys such as carbon steel, stainless steel, and kovar, and copper alloys such as white copper, nickel silver, bronze, and brass, in addition to iron and copper.

The positioning member 15 is sandwiched between the frame member 21. and the body portion 23 with a gap 37 between the positioning member 15 and the frame member 21 in a direction along the upper surface of the body portion 23 and with a gap between the positioning member 15 and the frame member 21 in a vertical direction. The gap 37 is formed around the positioning member 15. Accordingly, the positioning member 15 is displaceable on the body portion of the platform 17 between the frame member 21 and the body portion 23 in a sandwiched state. As the positioning member 15 is sandwiched so as to be displaceable, the positioning member 15 can slide according to the thermal expansion of the base 27, a difference in the thermal expansion coefficient between the base 27 and the material of the electronic part positioning jig 11 can be absorbed, and the element parts (for example, semiconductor elements) 13 and the base 27 can be joined together by the brazing material 25. Even in a case where a number of element parts are simultaneously brazed to a large base 27, since the positioning member is displaceable on the body portion, biting caused by thermal expansion can be surely prevented. In the meantime, in Fig. 1, reference numeral 13a represents a semiconductor element.

The brazing material for brazing may include metal paste such as silver paste, solder, or the like in addition to silver-based, phosphor-copper-based, and aluminum-based brazing materials, and are not particularly limited.

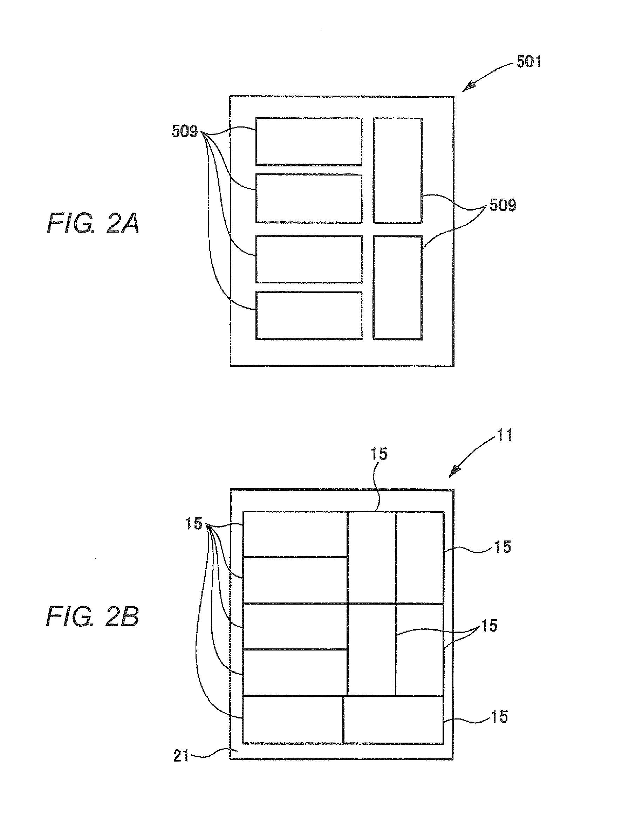

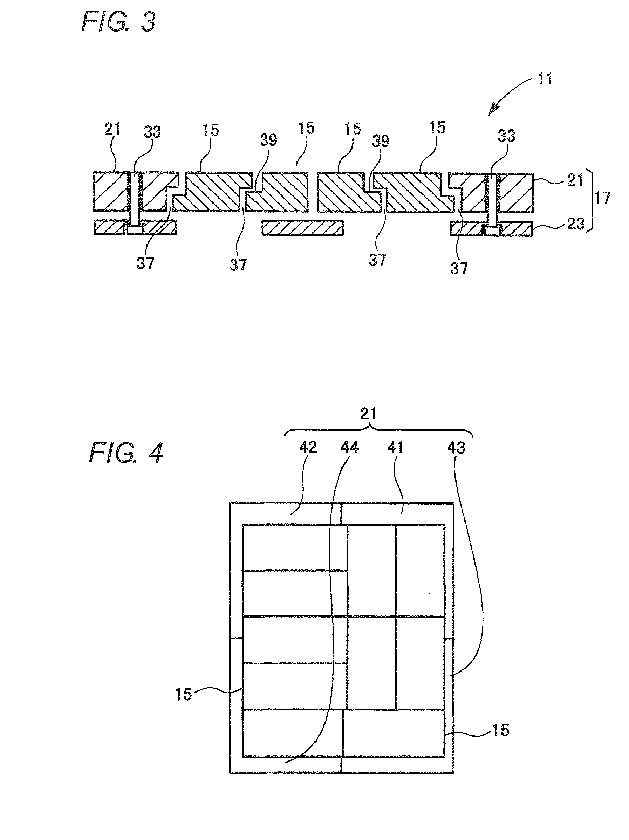

Fig. 2A is a plan view of a related-art electronic part positioning jig 501 according to a comparative example, and Fig. 2B is a plan view of an electronic part positioning jig 11 according to Embodiment 2 of the present invention, and Fig. 3 is a cross-sectional view of an electronic part positioning jig 11 according to a modified example which includes engaging portions 39 at adjacent portions of positioning members 15. Element part housing portions may be formed in the surfaces of the positioning members 15 shown in Fig. 2A and 2B, and Fig. 3 according to the shape of the element parts.

In the modified example of the electronic part positioning jig shown in Fig. 3, the positioning member 15 is divided into a plurality of positioning members, and only the outer peripheral edges of the positioning members 15 which are provided outside are sandwiched by the frame member 21 of the platform 17. The plurality of divided positioning members 15 include engaging portions 39 which engage between mutually adjacent positioning members 15 when the positioning members 15 are arranged in a state of aggregation. For this reason, although in the configuration of the related-art electronic part positioning jig, as shown in Fig. 2A, respective positioning members 509 are arranged apart from each other, in the electronic part positioning jig 11 according to Embodiment 2, as shown in Fig. 2B, the positioning members may be continuously arranged via the engaging portions 39. Additionally, as shown in Fig. 3, the body portion 23 may have openings so that portions of the back surfaces of the positioning members are exposed. Electronic part housing portions can be formed even in the back surfaces of the positioning members and positioning can be made using both surfaces of the electronic part positioning jig.

As shown in Fig. 3, each engaging portion 39 can be formed to have a step-shaped portion formed at the positioning member 15, and an inverted step-shaped portion which fits to this step-shaped portion. In addition, even in the engaging structure between these step-shaped portions, as described above, the positioning members 15 are arranged with the gaps 37 along the direction of the upper surface of the body portion 23. This arrangement is provided so as not to spoil the function of absorbing the difference in thermal expansion coefficient between the base and the electronic part positioning jig.

As such, in the electronic part positioning jig 11, the plurality of positioning members 15 are arranged adjacent to each other horizontally and vertically on the body portion 23 of the platform 17, and the positioning members 15 which are arranged outside have outer peripheral edges sandwiched by the body portion 23 and the frame member 21, whereby falling off of the positioning members 15 is suppressed. The positioning members 15 which are arranged inside adjacent to the outside positioning members 15 whose falling off is suppressed have engaging portions 39 at adjacent portions sandwiched by the outside positioning members 15 and the body portion 23, whereby falling off of the positioning members 15 is prevented. That is, all the positioning members 15 become slidable, and falling off thereof is suppressed.

In addition, it is preferable that the positioning members 15 form an array of 2x2 positioning members or more which are in contact with each other. According to this configuration, since the positioning members 15 are adjacent to each other, and there is no frame member 21 between the positioning members 15, element parts can be arranged in high density, and the element parts and the base can be brazed. Additionally, it is preferable that the positioning members 15 form an array exceeding an array of 2x2 positioning members which are in contact with each other, and adjacent portions of at least one or more sets of positioning members 15 are formed with the engaging portions 39 which prevent the falling off of the positioning members 15. According to this configuration, even if an array of a number of positioning members exceeding 2x2 is formed, the positioning members 15 do not fall off. Moreover, as finely dividing positioning members, the thermal stress generated between the electronic part positioning jig and the base can be made small.

Fig. 4 is a cross-sectional view of an electronic part positioning jig 11 according to a modified example in which the frame member 21 is divided.

It may be preferable that the frame member 21 is dividable into a plurality of frame members. In the modified example of the electronic part positioning jig shown in Fig. 4, the frame member 21 is dividable into a first frame member 41, a second frame member 42, a third frame member 43, and a fourth frame member 44. By making the frame member 21 dividable, in a case where some of the plurality of positioning members. 15 requires replacement, if the fixation of only the first frame member 41 or the second frame member 42, which directly or indirectly fixes a target positioning member 15 which requires replacement, is released, the target positioning member 15 can be detached, and the other positioning members 15 which do not require replacement remain fixed, thus reducing replacement work.

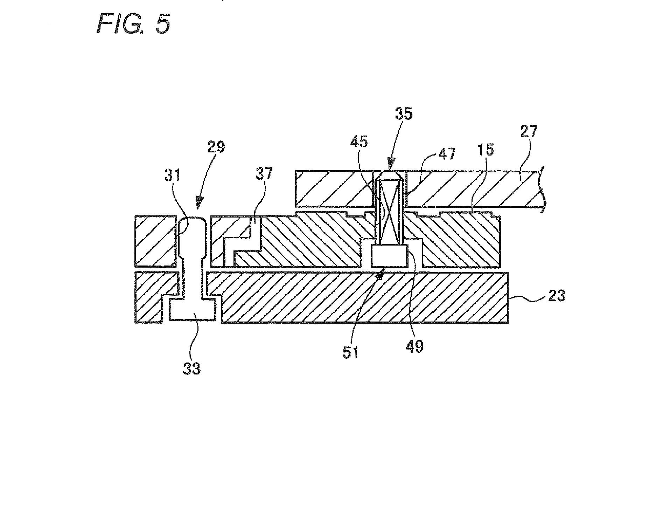

Fig. 5 is a cross-sectional view of an electronic part positioning jig 11 related to a modification in which a positioning member 15 of the invention is provided with a pin 35.

The surface of the positioning member 15 is provided with a positioning pin 35. The pin 35 is made of metal, and is press-fitted into a pin hole 45 formed in the positioning member 15 from the back surface. Thereby, the pin 35 can be replaced if the pin is worn, carburized, and expended. Moreover, the positioning pin 35 is provided on the surface of the positioning member 15, and if the pin 35 is inserted into a positioning hole formed in the base 27, the gap 37 between the positioning members can be appropriately formed.

The pin 35 has a protruding portion 47 which faces the pin hole 45 formed in the positioning member 15 and protrudes to an element part mounting surface of the positioning member 15, and a base end portion 49 opposite to the protruding portion 47, and the base end portion 49 is formed with a large-diameter portion 51 which has a diameter larger than the protruding portion 47. According to this configuration, the pin 35 does not slip out from the front side of the positioning member 15, and if the frame member 21 and the body portion 23 are separated from each other, the pin 35 can be easily replaced. Additionally, it is preferable that a gap be present between the pin 35 and the pin hole 45. If there is a gap between the pin 35 and the positioning member 15 made of carbon, the pin 35 can easily slip out from the positioning member 15 even if carburizing has occurred.

Herein, carburizing means that carbon enters metal, and if the pin is carburized, a problem occurs in that the pin becomes thick or its surface becomes coarse, and thus the pin does not slip out.

Next, the operation of the electronic part positioning jig 11 having the above configuration will be described.

In the electronic part positioning jig 11, the positioning member 15 is arranged on the body portion 23 of the platform 17, and the frame member 21 fixed to the body portion 23 by the joining means 29 sandwiches the positioning member 15 between the frame member 21 and the body portion 23. The positioning member 15 sandwiched by the body portion 23 and the frame member 21 is made displaceable on the plane of the body portion 23. Thereby, as the positioning member 15 is displaced (slides freely) on the plane, each positioning member 15 slides according to the thermal expansion of the base 27, and the thermal expansion difference caused by a difference in the thermal expansion coefficient between the base 27 and the material of the electronic part positioning jig 11 can be absorbed. In addition, even if the whole electronic part positioning jig 11 is erected in the vertical direction or inverted, the positioning member 15 does not fall off the platform 17. Additionally, in a case where each positioning member 15 is provided with the pin 35, the base 27 and the element part 13 also do not fall off the platform 17.

Additionally, since a plurality of the positioning members 15 are provided, and are slidably housed in the platform 17, the positioning members 15 do not bite each other due to a temperature difference in the temperatures (for example 0 to 50°C) when element parts and the base are brazed and removed. Since the platform 17 has a dividable structure including the frame member 21 and the body portion 23, if damage or wear occurred, only some of the positioning members 15 can be easily replaced.

While the related-art electronic part positioning jig 11 is repeatedly used, soiling resulting from oxidization, chipping, flux or the like occurs in the electronic part housing portions 19, and some of the electronic part housing portions 19 may not be used. In a case where an element part 13 to be brazed is small, in a case where high positioning precision is necessary, or in a case where a large number of element parts 13 are to be brazed, some of the electronic part housing portions tend to become unusable. If some of the electronic part housing portions 19 become unusable, a problem of productivity may occur. However, since the electronic part positioning jig 11 includes the positioning members 15 and the platform 17, and the platform 17 connects the frame member 21 and the body portion 23 by the joining means 29, even in a case where the positioning members 15 require replacement due to factors such as damage, wear, or the like, of the electronic part housing portions 19, the positioning members 15 can be removed and replaced only by removing the joining means 29 and disassembling the frame member 21 and the body portion 23, or by destroying the frame member 21 or the body portion 23.

Since the platform 17 includes the frame member 21 and the body portion 23 which houses the positioning members 15, and the positioning members 15 are sandwiched by the frame member 21 and the body portion 23, the positioning members 15 do not fall apart. Since the frame member 21 and the body portion 23 can be assembled simply by removing and separating the joining means 29, a positioning member which requires replacement can be easily replaced with the positioning member 15 without wear or chipping.

In the electronic part positioning jig 11, the positioning members 15 in which the electronic part housing portions 19 are exposed are assembled to the platform 17 including the frame member 21 and the body portion 23 so as to be slidable and so as not to be removed. For this reason, even in a case where the element part 13 and the positioning members 15 bite each other, the base (substrate) 27 brazed to the element parts 13 is strongly pulled apart, so that the element parts 13 can be pulled apart from the positioning members 15 without the positioning members 15 being separated from the electronic part positioning jig 11.

Since the electronic part positioning jig 11 slidably has the plurality of positioning members 15, even if the thermal expansion coefficient of the base 27 to be brazed and the thermal expansion coefficient of the electronic part positioning jig are different from each other, the positioning member 15 can slide to prevent the element parts 13 and the positioning members 15 from strongly biting each other.

Moreover, as the positioning members 15 slide freely, the stress between the positioning members and the base can be relaxed. For this reason, for example, in a case where it is necessary to mount a plurality of element parts (semiconductor elements) on a ceramic substrate as a base, in order to reduce the number of times of mounting of the semiconductor elements, it is desirable to simultaneously mount a number of element parts 13 on the base 27 and divide the base after brazing. In such a case, the configuration of the above-described embodiment is particularly favorable. Moreover, in a case where the base is divided after brazing, it is desirable to form a dividing groove 53 as shown in Fig. 1 in advance in the base (ceramic substrate) 27. Since the dividing groove 53 tends to crack due to a difference in thermal expansion between the base (ceramic substrate) 27 and the positioning members 15 at the time of brazing, the configuration of the above-described embodiment is particularly effective even in preventing this cracking.

Accordingly, in the electronic part positioning jig 11 according to the embodiment, even if the platform 17 which supports the positioning members 15 for positioning the element parts 13 is inverted, the positioning members 15 and the element parts 13 do not fall off the platform 17, and the positioning members can be easily replaced.

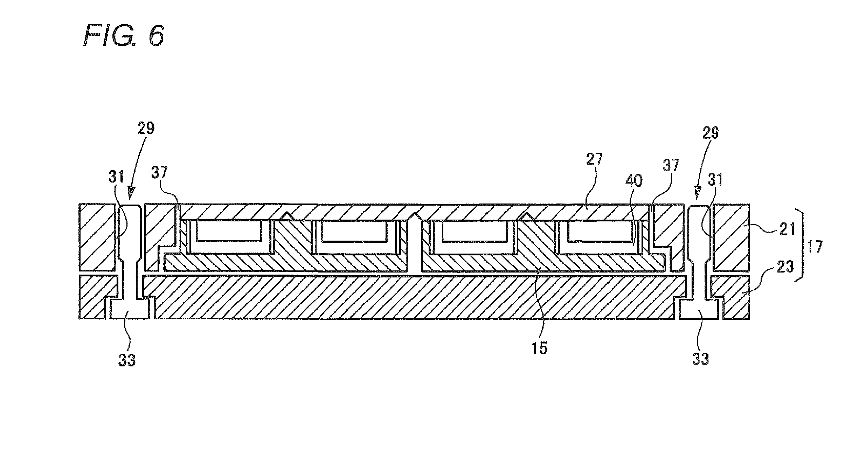

Fig. 6 is a cross-sectional view of a modified example of the electronic part positioning jig, and shows a case where the positioning members 15 is positioning containers 40 of packages of electronic parts, instead of the electronic parts as the element parts.

While the present invention has been shown and described with reference to certain illustrative embodiments thereof, it will be understood by those skilled in the art that various changes in form and details may be made therein without departing from the spirit and scope of the invention as defined by the appended claims.

## Claims

1. An electronic part positioning jig comprising:
a positioning member which is made of carbon and positions an element part;
and
a platform which supports the positioning member on a plane,
wherein the platform includes:
a frame member which receives the positioning member; and
a body portion which fixes the frame member, and
wherein the positioning member is sandwiched between the frame member and the body portion so as to be displaceable on the body portion by the frame member being fixed to the body portion by joining means.

2. The electronic part positioning jig according to claim 1,
wherein the positioning member is divided into a plurality of positioning members, and
wherein each of the plurality of divided positioning members includes an engaging portion which engages with an engaging portion of an adjacent divided positioning member, and only outer peripheral edges of positioning members which are arranged outside are sandwiched by the frame member.

3. The electronic part positioning jig according to claim 1,
wherein the joining means includes a male screw which is inserted through and fastened to a hole formed to pass through the frame member or the body portion.

4. The electronic part positioning jig according to any one of claims 1 to 3,
wherein the frame member is dividable into a plurality of frame members.

5. The electronic part positioning jig according to any one of claims 1 to 4,
wherein a surface of the positioning member is provided with a positioning pin.

6. The electronic part positioning jig according to claim 5,
wherein the positioning pin includes a pin inserted into a pin hole formed in the positioning member from a back surface.

7. The electronic part positioning jig according to claim 6,
wherein the positioning pin includes a protruding portion which protrudes from the surface of the positioning member, and a base end portion opposite to the protruding portion, and
wherein the base end portion includes a large-diameter portion having a diameter larger than that of the protruding portion.

8. The electronic part positioning jig according to any one of claims 5 to 7,
wherein the positioning pin is made of metal.

9. The electronic part positioning jig according to any one of claims 1 to 8,
wherein the carbon of the positioning member is a C/C composite material, a graphite material, a carbon material in which glassy carbon is coated on a surface of the C/C composite material or the graphite material, or a carbon material in which a coat of pyrolytic carbon is formed on the surface of the C/C composite material or the graphite material.
